# EUROPEAN PATENT APPLICATION

(11) **EP 2 445 012 A2**
(43) Date of publication of application: **25.04.2012**
(21) Application number: 11185883.3
(22) Date of filing: 20.10.2011
(51) Int. Cl.: H01L 31/0216

(54) **Semiconductor substrate**

(30) Priority: 22.10.2010 TW 099220535
(71) Applicant: Neo Solar Power Corp., Hsinchu City 300 (TW)
(72) Inventor: Wu, Meng-Hsiu, 300 Hsinchu City (TW); Tai, Yu-Wei, 300 Hsinchu City (TW); Chen, Wei-Ming, 300 Hsinchu City (TW); Chen, Yang-Fang, 300 Hsinchu City (TW)
(74) Representative: 2K Patentanwälte Blasberg Kewitz & Reichel

(57) **Abstract**

A semiconductor substrate includes a substrate, at least a semiconductor layer, a first anti-reflection layer, and a second anti-reflection layer. The semiconductor layer is disposed on the substrate. The first anti-reflection layer is disposed on the semiconductor layer. The second anti-reflection layer is disposed on the first anti-reflection layer. The second anti-reflection layer is a discontinuous layer with the capability of photon conversion.

## Description

### BACKGROUND OF THE INVENTION

### Field of Invention

The present invention relates to a substrate and, in particular, to a semiconductor substrate.

### Related Art

Due to the decrease of the petroleum reserve, the increase of oil price, and the agreement of carbon dioxide emissions reduction between many industrial countries, it is desired to develop the technology and apparatus of renewable energy such as solar energy, wind energy and hydropower. In particular, the technology of the solar energy is the most popular one. This is because the solar light can cover every area on the earth, and the energy conversion from the solar energy does not cause environmental pollution. For example, it is unnecessary to apply additional energy, which may cause the green house effect, for the solar energy conversion.

The general solar cells have many different materials and structure designs. The basic structure thereof includes an N-type or P-type semiconductor layer, an anti-reflection layer, and metal electrodes. The N-type or P-type semiconductor layer can generate the photovoltaic effect. The anti-reflection layer can reduce the reflection of the incident light so as to enhance the current generated by the semiconductor layer. The metal electrodes are used to connect the solar cell with an external load.

However, the conversion efficiency from the solar energy to electricity may be easily restricted by the amount of the incident light and the utility rate thereof. Therefore, it is an important subject of the present invention to provide a semiconductor substrate that can increase the amount of the incident light and the utility rate thereof in a solar cell, thereby improving the photoelectric conversion efficiency of the solar cell.

### SUMMARY OF THE INVENTION

In view of the foregoing subject, an objective of the present invention is to provide a semiconductor substrate that can increase the amount of the incident light and the utility rate thereof in a solar cell, thereby improving the photoelectric conversion efficiency of the solar cell.

To achieve the above objective, the present invention discloses a semiconductor substrate including a substrate, at least a semiconductor layer, a first anti-reflection layer, and a second anti-reflection layer. The semiconductor layer is disposed on the substrate. The first anti-reflection layer is disposed on the semiconductor layer. The second anti-reflection layer is disposed on the first anti-reflection layer. The second anti-reflection layer is a discontinuous layer with the capability of conversing the incident light (photons) to a wavelength or a spectrum of wavelengths that can be absorbed by the N+/P or P+/N semiconductor solar cells.

In one embodiment of the invention, the first anti-reflection layer and the second anti-reflection layer are formed by depositing, sputtering, evaporating, coating, spin coating, printing, ink-printing, or their combinations.

In one embodiment of the invention, the substrate is a monocrystalline silicon substrate, a polycrystalline silicon substrate, an amorphous silicon substrate, or a microcrystalline silicon substrate.

In one embodiment of the invention, the semiconductor layer is an N-type semiconductor layer or a P-type semiconductor layer.

In one embodiment of the invention, the material of the first anti-reflection layer includes silicon oxide, silicon nitride, silicon oxynitride, or aluminum oxide.

In one embodiment of the invention, the second anti-reflection layer includes a plurality of photon conversion particles. The material of the photon conversion particles includes Al₂O₃, MgF₂, Ta₂O₃, Nb₂O₅, TiO₂, SiO₂, ZrO₂, ZnS, fluorescent powder, organic fluorescent pigment, polymer fluorescent material, inorganic fluorescent material, quantum dot fluorescent material, fluorescent hybrid material, phosphorescent powder, dye, or their combinations. Preferably, the photon conversion particles can be mixed in a polymer binder so as to facilitate forming a layer.

In one embodiment of the invention, the second anti-reflection layer includes a plurality of photon conversion particles mixed in polymer binder.

In one embodiment of the invention, the second anti-reflection layer is composed of a plurality of particle groups, which include a plurality of particles.

In one embodiment of the invention, the numbers of the particles in the particle groups are the same or different.

In one embodiment of the invention, the particle groups have regular or irregular shape(s).

In one embodiment of the invention, the shapes of the particle groups are the same, substantially the same, or different.

In one embodiment of the invention, the particle groups are regularly or irregularly distributed.

In one embodiment of the invention, the semiconductor substrate further includes an electrode layer disposed on the first anti-reflection layer. Part of the electrode layer can be covered by the second anti-reflection layer.

### BRIEF DESCRIPTION OF THE DRAWINGS

The invention will be better understood from the detailed description and accompanying drawings, which are given for illustration only, and thus are not limitative of the present invention, and wherein:

FIG. 1 is a cross-section view of a semiconductor substrate according to a first preferred embodiment of the present invention;

FIG. 2 is a cross-section view of a semiconductor substrate according to a second preferred embodiment of the present invention;

FIG. 3 is a cross-section view of a semiconductor substrate according to a third preferred embodiment of the present invention;

FIGS. 4 and 5 are cross-section views of a semiconductor substrate according to a fourth preferred embodiment of the present invention; and

FIG. 6 is a plan view of FIG. 5.

### DETAILED DESCRIPTION OF THE INVENTION

The present invention will be apparent from the following detailed description, which proceeds with reference to the accompanying drawings, wherein the same references relate to the same elements.

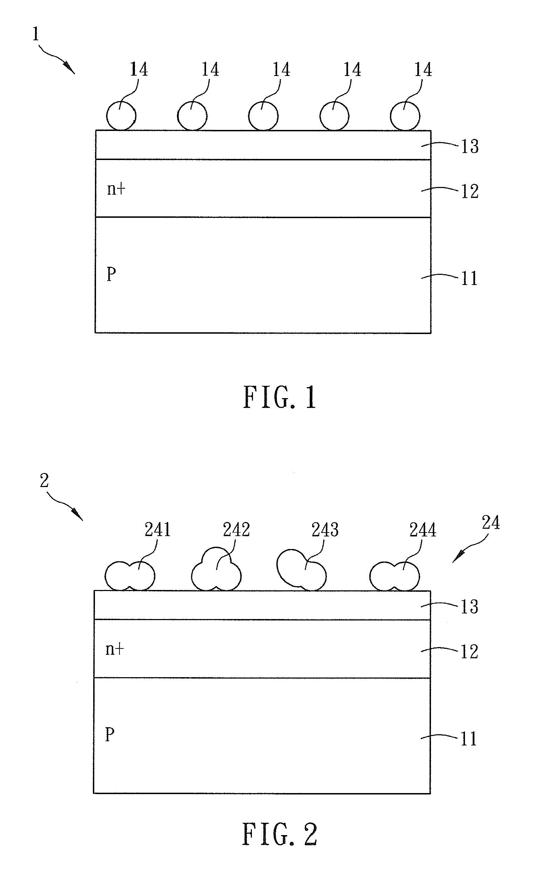

FIG. 1 is a cross-section view of a semiconductor substrate 1 according to a first preferred embodiment of the present invention. Referring to FIG. 1, the semiconductor substrate 1 includes a substrate 11, at least a semiconductor layer 12, a first anti-reflection layer 13, and a second anti-reflection layer 14. The semiconductor layer 12 is disposed on the substrate 11. The first anti-reflection layer 13 is disposed on the semiconductor layer 12. The second anti-reflection layer 14 is disposed on the first anti-reflection layer 13. The second anti-reflection layer 14 is a discontinuous layer with the capability of photon conversion.

The substrate 11 can be a monocrystalline silicon substrate, a polycrystalline silicon substrate, an amorphous silicon substrate, or a microcrystalline silicon substrate. Besides, the substrate 11 can be an N-type semiconductor substrate or a P-type semiconductor substrate. In this embodiment, the substrate 11 is a P-type semiconductor substrate. In addition, the substrate 11 can be applied to a solar cell.

The semiconductor substrate 1 includes at least one semiconductor layer 12 (e.g. an N-type semiconductor layer). In practice, if the substrate 11 is an N-type semiconductor substrate, the semiconductor layer 12 is a P-type semiconductor layer; otherwise, if the substrate 11 is a P-type semiconductor substrate, the semiconductor layer 12 is an N-type semiconductor layer. In details, when the substrate 11 is an N-type semiconductor substrate, the P-type semiconductor material is diffused into the N-type semiconductor substrate so as to form a P-type semiconductor layer on the N-type semiconductor substrate. Alternatively, when the substrate 11 is a P-type semiconductor substrate, the N-type semiconductor material is diffused into the P-type semiconductor substrate so as to form an N-type semiconductor layer on the P-type semiconductor substrate. When the P-type and N-type semiconductor layers are in contact with each other, the electrons in the N-type semiconductor layer move and enter the P-type semiconductor layer to fill the holes therein. Around the P-N junction, the recombination of the electron and hole can cause a carrier depletion region, and an internal electronic field can be formed due to that the P-type and N-type semiconductor layers carry negative and positive charges, respectively. When the solar light reaches the P-N structure, the P-type and N-type semiconductor layers can absorb the solar light to generate electron-hole pair. The internal electronic field provided by the depletion region can drive the electrons inside the semiconductor layer 12 to flow within the cell.

The first anti-reflection layer 13 is disposed on the semiconductor layer 12. Since the difference between the refraction indexes of air and silicon is obvious, the reflection of light beams usually occurs at the interface therebetween. Accordingly, the present invention provides the first anti-reflection layer 13 made of silicon nitirde on the semiconductor layer 12 for reducing the reflection of the incident light. Moreover, the first anti-reflection layer 13 is processed on a rough surface, so that it can provide outstanding anti-reflection effect and passivation function, thereby improving the entire performance. In this embodiment, the material of the first anti-reflection layer 13 may include silicon oxide, silicon oxynitride, aluminum oxide, or any material that can passivate the silicon surface.

The second anti-reflection layer 14 is disposed on the first anti-reflection layer 13, and it is a discontinuous layer with the capability of photon conversion. The discontinuous second anti-reflection layer 14 includes a plurality of photon conversion particles. The shape of the photon conversion particles is schematically indicated as circle, but in reality it could be of any regular or irregular shapes.

Preferably, the material of the photon conversion particles mixed in the second anti-reflection layer 14 includes Al₂O₃, MgF₂, Ta₂O₃, Nb₂O₅, TiO₂, SiO₂, ZrO₂, ZnS, fluorescent powder, organic fluorescent pigment, polymer fluorescent material, inorganic fluorescent material, quantum dot fluorescent material, fluorescent hybrid material, phosphorescent powder, dye, or their combinations. When the incident solar light irradiates the photon conversion particles (e.g. fluorescent powder particles, not shown) in the second anti-reflection layer 14, the fluorescent powder particles can absorb a part of light with shorter wavelength (e.g. UV light), and releases the light with longer wavelengths (e.g. visible light and infrared light). Accordingly, if the semiconductor substrate 1 is applied to a solar cell, most of the light entering the semiconductor layer 12 may have the wavelength within the range applicable for the desired photoelectric conversion, thereby increasing the utility rate of the incident light entering the solar cell. In this embodiment, the first anti-reflection layer 13 and the second anti-reflection layer 14 can be formed by depositing, sputtering, evaporating, coating, spin coating, printing, ink-printing, or their combinations.

FIG. 2 is a cross-section view of a semiconductor substrate 2 according to a second preferred embodiment of the present invention. The semiconductor substrate 2 of FIG. 2 is different from those of FIG. 1 in the structure of the second anti-reflection layer 24. In this embodiment, the discontinuous second anti-reflection layer 24 is composed of a plurality of particle groups 241, 242, 243 and 244. Each of the particle groups 241-244 may include a plurality of above-mentioned particles (not shown). Herein, the numbers of the particles in the particle groups 241-244 are the same or different. The particle groups 241-244 may have regular shape (see particle group 241) or irregular shapes (see particle group 243). The shapes of the particle groups 241-244 may be the same (see particle groups 241 and 244), substantially the same, or different (see particle groups 241, 242 and 243).

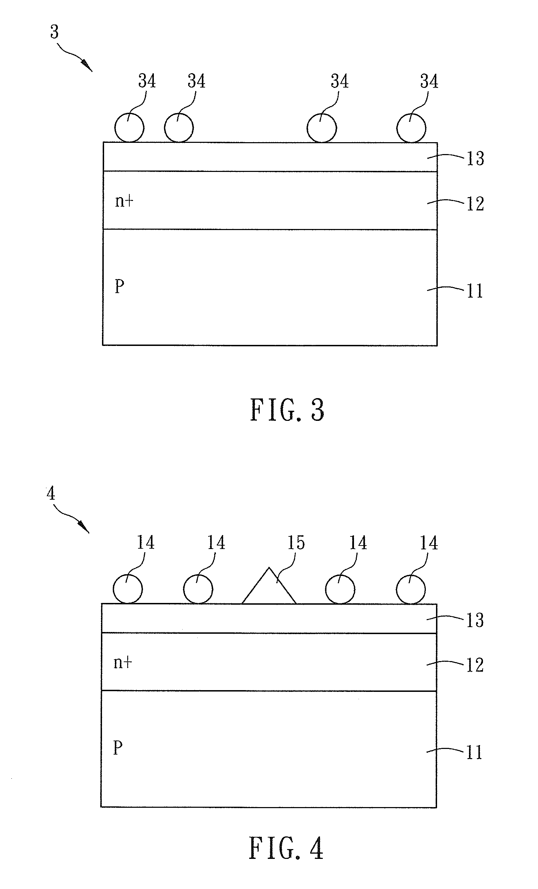

FIG. 3 is a cross-section view of a semiconductor substrate 3 according to a third preferred embodiment of the present invention. The semiconductor substrate 3 of FIG. 3 is different from those of FIG. 1 in the structure of the second anti-reflection layer 34. In this embodiment, the discontinuous second anti-reflection layer 34 is composed of a plurality of particle groups. Each of the particle groups may include a plurality of above-mentioned particles (not shown). Herein, the particle groups of the second anti-reflection layer 34 are regularly or irregularly distributed.

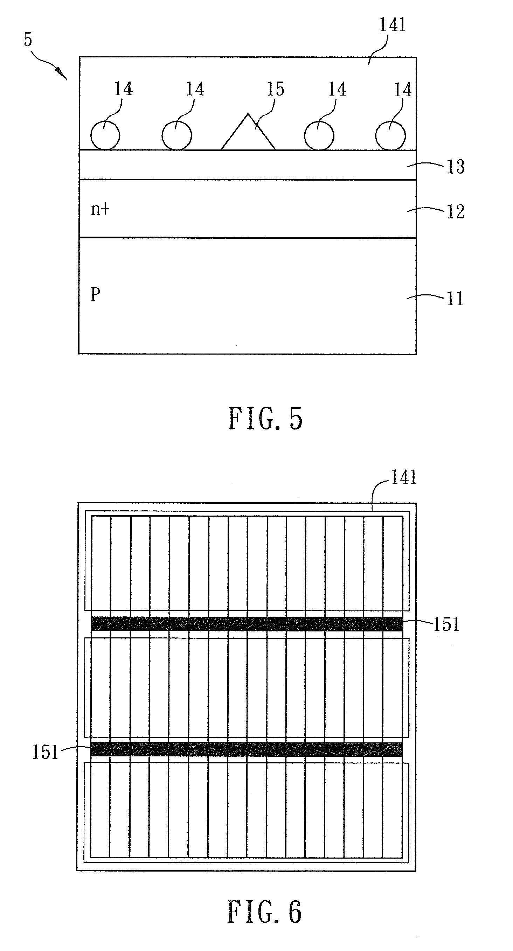

FIG. 4 is a cross-section view of a semiconductor substrate 4 according to a fourth preferred embodiment of the present invention. Compared with those of FIG. 1, the semiconductor substrate 4 of FIG. 4 further includes an electrode layer 15 disposed on the first anti-reflection layer 13. The electrode layer preferably includes a plurality of bus bar electrodes (151 as shown in FIG. 6) and a plurality of finger electrodes (cross section shown as a triangle). Each finger electrode is electrically connected with at least one bus bar electrode. When the semiconductor substrate 4 absorbs the solar light and converts it into electrons, the finger electrodes can collect the generated electrons and send them to the corresponding bus bar electrode(s). Finally, the electrons generated by the photoelectric conversion can be transmitted to the external load through the bus bar electrodes.

As the semiconductor substrate 5 shown in FIG. 5, layer 141 is a polymer binder that used for facilitating applying photon conversion particles, such as in printing or spin coating processes.

FIG. 6 is a plan view of FIG. 5. As show the layer 141 is dissected by the bus bar electrodes 151 into discontinuous segments. The advantage of clearing out the polymer binder in the bus bar area is to avoid interfering the sequential soldering and solar cell connecting processes.

In summary, the semiconductor substrate of the present invention has a second anti-reflection layer disposed on the first anti-reflection layer. The second anti-reflection layer is a discontinuous layer with the capability of photon conversion. Preferably, the material of the second anti-reflection layer is selected to convert the original wavelength of the incident light to a longer wavelength that is suitable for performing the photoelectric conversion. This configuration can increase the utility rate of the incident light and improve the photoelectric conversion efficiency.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A semiconductor substrate, comprising:
a substrate;
at least a semiconductor layer disposed on the substrate;
a first anti-reflection layer disposed on the semiconductor layer; and
a second anti-reflection layer disposed on the first anti-reflection layer, wherein the second anti-reflection layer is a discontinuous layer with the capability of photon conversion.

2. The semiconductor substrate according to claim 1, wherein the first anti-reflection layer and the second anti-reflection layer are formed by depositing, sputtering, evaporating, coating, spin coating, printing, ink-printing, or their combinations.

3. The semiconductor substrate according to claim 1 or 2, wherein the first anti-reflection layer is processed on a rough surface.

4. The semiconductor substrate according to claim 1, wherein the material of the first anti-reflection layer comprises silicon oxide, silicon nitride, silicon oxynitride, or aluminum oxide.

5. The semiconductor substrate according to any of the preceding claims, wherein the second anti-reflection layer comprises a plurality of photon conversion particles.

6. The semiconductor substrate according to claim 5, wherein the material of the photon conversion particles comprises Al₂O₃, MgF₂, Ta₂O₃, Nb₂Oₛ, TiO₂, SiO₂, ZrO₂, ZnS, fluorescent powder, organic fluorescent pigment, polymer fluorescent material, inorganic fluorescent material, quantum dot fluorescent material, fluorescent hybrid material, phosphorescent powder, dye, or their combinations.

7. The semiconductor substrate according to claim 5, wherein the second anti-reflection layer further comprises polymer binder.

8. The semiconductor substrate according to any of the preceding claims, wherein the second anti-reflection layer is composed of a plurality of particle groups, and the particle groups comprise a plurality of particles.

9. The semiconductor substrate according to claim 8, wherein the numbers of the particles in the particle groups are the same or different.

10. The semiconductor substrate according to claim 8 or 9, wherein the particle groups have regular or irregular shape.

11. The semiconductor substrate according to any of claims 8 to 10, wherein the shapes of the particle groups are the same, substantially the same, or different.

12. The semiconductor substrate according to any of claims 8 to 11, wherein the particle groups are regularly or irregularly distributed.

13. The semiconductor substrate according to any of the preceding claims, further comprising:
an electrode layer disposed on the first anti-reflection layer.

14. The semiconductor substrate according to claim 13, wherein the electrode layer comprises a plurality of bus bar electrodes and a plurality of finger electrodes.

15. The semiconductor substrate according to claim 14, wherein the second anti-reflection layer is dissected by the bus bar electrodes into the discontinuous layer.
